# EUROPÄISCHE PATENTANMELDUNG

(11) **EP 4 664 523 A1**
(43) Veröffentlichungstag der Anmeldung: **17.12.2025**
(21) Anmeldenummer: 24181724.6
(22) Anmeldetag: 12.06.2024
(51) Int. Cl.: H01L 23/38, H01L 23/427

(54) **VERFAHREN UND VORRICHTUNG ZUR ENTWÄRMUNG EINES ELEKTRISCHEN SYSTEMS**

(71) Anmelder: Siemens Aktiengesellschaft, 80333 München (DE)
(72) Erfinder: Boschert, Stefan, 85579 Neubiberg (DE); Grundmann, Jörn, 91091 Großenseebach (DE); Stegmeier, Stefan, 81825 München (DE); Walbrecker-Baar, Christian, 85757 Karlsfeld (DE)
(74) Vertreter: Siemens Patent Attorneys

(57) **Zusammenfassung**

Vorgeschlagen wird ein Verfahren und eine Vorrichtung zur Entwärmung eines elektrischen Systems (10) umfassend ein Erfassen einer zeitlichen Vorhersage eines Lastprofils, eine Berechnung einer benötigten maximalen Kühlleistung im nächsten Lastfall, und eine Erhöhung der Kühlleistung eines Kühlsystems durch eine Vorkühlung der Kühlkomponente (12) des Kühlsystems in einem vorgebbaren zeitlichen Abstand vor dem nächsten Lastfall.

## Beschreibung

Die vorliegende Erfindung betrifft ein Verfahren zur Entwärmung eines elektrischen Systems sowie eine Vorrichtung dazu.

### Stand der Technik

Die Leistungsfähigkeit und Lebensdauer elektronischer Bauelemente wie MOSFETs und IGBTs, elektrischen Maschinen wie beispielsweise Motoren oder Katalysatoren, in denen chemischer Prozesse ablaufen, hängen maßgeblich von ihrer Entwärmung ab bzw. den Temperaturen, denen sie ausgesetzt sind. Der Wärmefluss von der Hitzequelle zum Kühler muss oft über verschiedene Barrieren wie Bodenplatten, Substrate und thermische Interface-Materialien geleitet werden. Neben der Abkühlungseffektivität spielt auch die Abkühlungseffizienz eine wichtige Rolle. Die Zeit, die für die notwendige Entwärmung benötigt wird, bestimmt die Kühlungsart. Hohe Wärmeströme werden in der Regel durch Flüssigkeitskühlung bewältigt, während geringe Wärmeströme durch Luftkühlung ausreichend abtransportiert werden können.

Die Implementierung der Kühlung ist jedoch je nach Anwendung sehr aufwendig. Eine effektive Kühlung im Bereich elektronischer Bauelement, insbesondere im Bereich der Leistungselektronik, erfordert den Einsatz kostspieliger wärmeleitender Keramiken wie Aluminiumnitrid als Isolationsschichten. Die Verwendung aufwändig hergestellter Kühler sowie das Einbringen von Wärmespreizplatten beeinfluss die Größe und den Herstellungsprozess. Dies führt zu hohen Kosten aufgrund der Vielzahl unterschiedlicher Komponenten und Materialien. Insbesondere der Einsatz von Metall in großen Mengen und die Herstellungsverfahren, z.B. das Einpressen von Kühllamellen in stranggepresste Kühler erhöhen technischen Aufwand und Kosten.

Elektrische Systeme, insbesondere elektrische Maschinen, elektronische Anlagen sowie deren Anwendungsprozesse sind oft statisch ausgelegt. Das heißt, sie sind so optimiert, dass sie auch noch im extremen Temperaturereignisfall ausreichend gekühlt werden können. Dadurch werden Ressourcen oft verschwendet, da die Kühler insbesondere bei stark dynamischem Betrieb für die meiste Zeit überdimensioniert sind.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung trotz Ressourcenschonung Hochtemperatursituationen bewältigen können.

Diese Aufgabe wird durch die Merkmale des unabhängigen Patentanspruchs 1 sowie durch die Merkmale des Patentanspruchs 7 gelöst. Vorteilhafte Ausgestaltungen der Erfindung sind Gegenstand der Unteransprüche.

### Beschreibung der Erfindung

Das erfindungsgemäße Verfahren zur Entwärmung eines elektrischen Systems umfasst eine Erfassung einer zeitlichen Vorhersage eines Lastprofils, eine Berechnung einer benötigten maximalen Kühlleistung im nächsten Lastfall, und eine Erhöhung der Kühlleistung eines Kühlsystems durch eine Vorkühlung der Kühlkomponente des Kühlsystems in einem vorgebbaren zeitlichen Abstand vor dem nächsten Lastfall.

Dieses vorgeschlagene Verfahren hat den Vorteil, dass in der Kühlungsstrategie eine zeitliche Reaktion auf bevorstehende Lastfälle berücksichtigt wird.

Darüber hinaus hat das vorgeschlagene Verfahren den Vorteil eine Lösung für Sub-Systeme aber ebenso für übergeordnete System anzubieten, so dass die Lösung auf unterschiedlich hohen Systemebenen für die Auslegung der Kühlung des Systeme angewendet werden kann.

Dabei ist unter einem elektrischen System, insbesondere ein elektronisches System, ein elektrisches oder elektronisches Bauteil, ein elektronische Komponente oder Bauelement zu verstehen.

Unter einem Lastprofil ist im Kontext der Anmeldung eine Beschreibung des Verhaltens eines elektrischen Geräts oder einer elektrischen Last in Bezug auf den Stromverbrauch zu verstehen. Das Lastprofil zeigt typischerweise die Variation des Stromverbrauchs in Abhängigkeit von der Zeit, wobei verschiedene Betriebszustände und Laständerungen berücksichtigt werden. Messwerte für Lastprofile können auf verschiedene Weise erfasst werden, zum Beispiel durch Messungen an realen Geräten, durch Simulationen oder anhand von statistischen Daten. Eine manuelle Eingabe ist auch möglich.

Zur Berechnung der benötigten Kühlleistung: Aus Berechnungen und Modellen in der Entwicklungsphase des Produktes können Anhand der Lastmessung berechnet werden, wie hoch die Kühlleistung sein muss. Zur Wärmeentwicklung im elektrischen System trägt zunächst die intrinsische Wärmeentwicklung bei: Strom erzeugt Wärme durch thermische Widerstände im System. Hinzu kommen Umgebungsbedingungen. Diese Wärme muss aus dem System abtransportiert werden. Die Kühlleistung wird erbracht von verschiedenen Kühlern. Als Variable für die Berechnung kann beispielsweise eine Durchflussmenge eines Kühlmittels, entsprechend dem Wärmeabfluss, oder die Temperatur im einfacheren Fall herangezogen werden.

Bei einer Vorhersage wird die Berechnung komplexer. Hier können verschiedene Parameter berücksichtigt werden. Insbesondere basiert eine Vorhersage auf einer Musterhistorie, welche auf ein zukünftiges Profil schließen lässt. Es werden Betriebszeiten, Stoßlasten, Umweltmuster, wie Sonnenstand und Schattenwurf, sowie Jahreszeiten berücksichtigt. Dies wird bevorzugt mittels einer KI-basierte Mustererkennung (KI für künstliche Intelligenz) realisiert.

In einer vorteilhaften Variante des erfindungsgemäßen Verfahrens erfolgt eine Vorkühlung mittels einer chemischen Kühlkomponente, welche wenigstens einen zu lösenden Stoff und ein Lösungsmittel umfasst, deren Lösungsenthalpie positiv ist, indem ein Teil des zu lösenden Stoffes dem Lösungsmittel zugeführt wird.

In einer weiteren vorteilhaften Variante einer der vorstehend beschriebenen erfindungsgemäßen Verfahrensausführungen, erfolgt eine Vorkühlung mittels einer elektrischen Kühlkomponente, insbesondere mittels eines piezoelektrischen Elements, eines Peltierelements oder eines Kälteaggregats.

In einer weiteren vorteilhaften Variante einer der vorstehend beschriebenen erfindungsgemäßen Verfahrensausführungen, erfolgt eine Vorkühlung mittels Kühlung eines Phase-Change-Materials bis über den Phasenübergang.

In einer weiteren vorteilhaften Variante einer der vorstehend beschriebenen erfindungsgemäßen Verfahrensausführungen, erfolgt eine Vorkühlung mittels einer Gasexpansion.

In einer weiteren vorteilhaften Variante einer der vorstehend beschriebenen erfindungsgemäßen Verfahrensausführungen, erfolgt eine Vorkühlung alternativ oder zusätzlich mittels Anbindung einer zusätzlichen beweglichen Kühlkomponente.

Diese Ausführungsformen haben insbesondere den Vorteil, mit bewährten Technologien und in Kombination umgesetzt werden zu können. Es kann auf eine Maximalauslegung des Kühlsystems verzichtet werden, da mit dem vorgeschlagenen Verfahren der Peak vermindert wird. Es kann bevorzugt auf Kombinierbarkeit mit weiteren Kühlsystemen geachtet werden.

Die erfindungsgemäße Vorrichtung zur Entwärmung eines elektrischen Systems weist eine Steuereinheit auf, welche zum Erfassen einer zeitlichen Vorhersage eines Lastprofils ausgestaltet ist, eine Recheneinheit, welche zur Abschätzung einer benötigten maximalen Kühlleistung im nächsten Lastfall ausgestaltet ist, und ein Kühlungssystem mit wenigstens einer Kühlkomponente, wobei die Steuereinheit des Weiteren ausgestaltet ist, auf Basis der abgeschätzten benötigten maximalen Kühlleistung, die Kühlkomponente in einem vorgebbaren zeitlichen Abstand vor dem nächsten Lastfall vorzukühlen.

Damit ist die Vorrichtung geeignet ein elektrisches System, insbesondere ein elektronisches System, ein elektrisches oder elektronisches Bauteil, ein elektronische Komponente oder Bauelement zu entwärmen. Die Vorrichtung kann dazu ein Interface umfassen. Die Steuerung kann eine autarke Einheit sein, aber auch Teil einer vorhanden Einheit, insbesondere als Softwarekomponente, beispielsweise als Teil einer SPS- Steuerung oder eines PCs oder einem beliebigen softwarefähigem elektronischen Endgerät.

Eine SPS-Steuerung (Speicherprogrammierbare Steuerung) ist eine spezielle Art von Steuerungssystem, das in der Industrie zur Automatisierung von Maschinen und Anlagen eingesetzt wird. Sie besteht aus einer zentralen Steuereinheit, die über digitale und analoge Ein- und Ausgänge mit verschiedenen Sensoren, Aktoren und anderen Komponenten verbunden ist. Die SPS-Steuerung arbeitet nach einem vorher programmierten Ablaufplan, der in einem Speicher abgespeichert ist. Dieser Ablaufplan, auch als Steuerungsprogramm bezeichnet, legt fest, wie die Steuerung auf bestimmte Eingangssignale reagiert und welche Ausgangssignale sie entsprechend generiert. Das Programm kann durch den Anwender angepasst oder erweitert werden, um die gewünschte Funktionalität zu erreichen. SPS-Steuerungen sind in der Regel sehr robust und zuverlässig, da sie für den Einsatz in industriellen Umgebungen entwickelt wurden. Sie werden in verschiedenen Bereichen eingesetzt, wie beispielsweise in der Fertigungsindustrie, der Automobilindustrie, der Gebäudeautomatisierung und der Prozesssteuerung. Durch ihre Flexibilität, Programmierbarkeit und einfache Bedienung bieten SPS-Steuerungen eine effiziente Möglichkeit zur Automatisierung von Maschinen und Anlagen, wodurch Produktionsprozesse optimiert und automatisierte Abläufe realisiert werden können.

Unter einem PCs oder einem beliebigen softwarefähigem elektronischen Endgerät ist ein elektronisches Gerät zu verstehen, das konzipiert ist für eine Vielzahl von Aufgaben und aus einer Kombination von Hardwarekomponenten wie Prozessor, Speicher und Grafikkarte sowie Softwarekomponenten besteht. Abhängig von eben der Software können derartige Geräte komplexe Berechnungen, Datenverarbeitung und spezialisierte Anwendungen vornehmen. Die Leistungsfähigkeit des Endgeräts wird durch Faktoren wie Prozessorgeschwindigkeit, Arbeitsspeicher und Grafikleistung bestimmt. Ein Betriebssystem ermöglicht die Steuerung der Hardware und stellt bevorzugt dem Benutzer eine Benutzeroberfläche zur Verfügung.

In einer vorteilhaften Ausführungsform der erfindungsgemäßen Vorrichtung, umfasst das Kühlsystem wenigstens eine chemische Kühlkomponente, welche wenigstens einen zu lösenden Stoff und ein Lösungsmittel umfasst, deren Lösungsenthalpie positiv ist und wobei die Steuereinheit ausgestaltet ist, einen Teil des zu lösenden Stoffes dem Lösungsmittel zuzuführen.

Beispielsweise ist ein zu kühlendes Element mit einer Kühlvorrichtung thermisch leitend verbunden. Insbesondere schließt ein Behälter direkt an das zu kühlende Element an. In diesem Behälter befindet sich das Lösungsmittel. Sobald die aktive Vorkühlung benötigt wird, wird über eine Dosiervorrichtung aus einem Vorratsbehälter der zu lösende Stoff in den Behälter und somit in das Lösungsmittel zugeführt. Durch die positive Lösungsenthalpie kühlt sich das Lösungsmittel ab und somit wird dem thermisch leitend verbundenen Element Wärme entzogen. Dieser Prozess kann so lange wiederholt werden, bis die Mischung gesättigt ist. Dann wird die Mischung beispielsweise in einen Restebehälter gepumpt und mit neuem Lösungsmittel aus einem Lösungsmittelvorrat ersetzt. Die gesättigte Lösung kann in einem separaten Prozess, zum Beispiel durch Destillation wieder getrennt werden in Lösungsmittel und zu lösenden Stoff und wiederverwendet werden.

In einer alternativen Ausführungsform einer der vorstehend beschriebenen erfindungsgemäßen Vorrichtungsvarianten, umfasst das Kühlsystem wenigstens eine elektrische Kühlkomponente, insbesondere ein piezoelektrisches Element, ein Peltierelement oder ein Kälteaggregat.

In einer weiteren Ausführungsform einer der vorstehend beschriebenen erfindungsgemäßen Vorrichtungsvarianten, umfasst das Kühlsystem wenigstens eine Kühlkomponente mit einem Phase-Change-Material.

In einer alternativen Ausführungsform einer der vorstehend beschriebenen erfindungsgemäßen Vorrichtungsvarianten, umfasst das Kühlsystem wenigstens eine Kühlkomponente mit einer Gaskartusche.

In einer alternativen Ausführungsform einer der vorstehend beschriebenen erfindungsgemäßen Vorrichtungsvarianten, umfasst das Kühlsystem wenigstens eine mechanisch verschiebbare Kühlkomponente.

In vielen elektrischen Systemen, in elektrischen Geräte oder elektronischen Bauteilen, kommen Kühlsysteme vor, insbesondere wenn diese Systeme oder einzelne Komponenten darin eine gewisse Wärme erzeugen oder empfindlich auf Hitze reagieren. Einige Beispiele für Geräte und Bauteile mit Kühlungsbedarf sind: Computer und Laptops, insbesondere deren Prozessoren, Grafikkarten und andere Komponenten darin erzeugen Wärme und erfordern Kühlung, um eine Überhitzung zu vermeiden. Server, insbesondere in Rechenzentren, aufgrund der hohen Rechenleistung und der kontinuierlichen Nutzung erzeugen Server und Rechenzentren große Mengen an Wärme und sind auf ausgeklügelte Kühlungssysteme angewiesen, um eine stabile Betriebstemperatur aufrechtzuerhalten. Elektronische Bauteile, insbesondere leistungsstarke Transistoren, integrierte Schaltkreise (Integrated Circuits, ICs) und andere elektronische Komponenten können Hitze erzeugen und benötigen Kühlung, um eine optimale Leistung und Langlebigkeit zu gewährleisten. Elektrische Maschinen, insbesondere in Elektrofahrzeugen die Elektromotoren, aber auch die Batterien und Leistungselektronik in Elektrofahrzeugen erzeugen Wärme und erfordern Kühlung, um eine optimale Leistung und Sicherheit zu gewährleisten. In verschiedenen industriellen Anwendungen, in den Maschinen und Anlagen, wie beispielsweise im Maschinenbau, in der Fertigung und der Energieerzeugung werden Kühlsysteme verwendet, um die Betriebstemperatur von Geräten und Anlagen zu regulieren und Überhitzung zu verhindern.

Die vorgeschlagene Lösung und ihre Ausführungsformen haben den Vorteil, dass das Kühlungssystem nicht auf die Maximaltemperatur ausgelegt sein muss und ist demnach ressourcenschonend konstruierbar. Eine derartige Kühlvorrichtung kann nicht nur zeitlich auf bevorstehende Temperaturlastfälle vorbereitet werden, sondern der gesamte zeitliche Temperaturverlauf wird berücksichtigt.

Weitere Merkmale, Eigenschaften und Vorteile der vorliegenden Erfindung ergeben sich aus der nachfolgenden Beschreibung unter Bezugnahme auf die beiliegende Figuren. Darin zeigen schematisch:
- Figur 1: ein Lastprofil in Abhängigkeit von der wochentageabhängigen Energieversorgung,
- Figur 2: ein Lastprofil in Abhängigkeit von der Jahreszeit,
- Figur 3: eine schematische Seitenansicht eines zu entwärmenden elektrischen Systems 10 mit elektronischen Bauelementen 11, welche mittels wärmeleitfähiger Anbindung 12 entwärmt werden können,
- Figur 4: eine Temperaturverlaufskurve eines Elektromotors bei Betrieb mit veränderlicher Drehzahl,
- Figur 5: ein Vorkühlsystem 12.

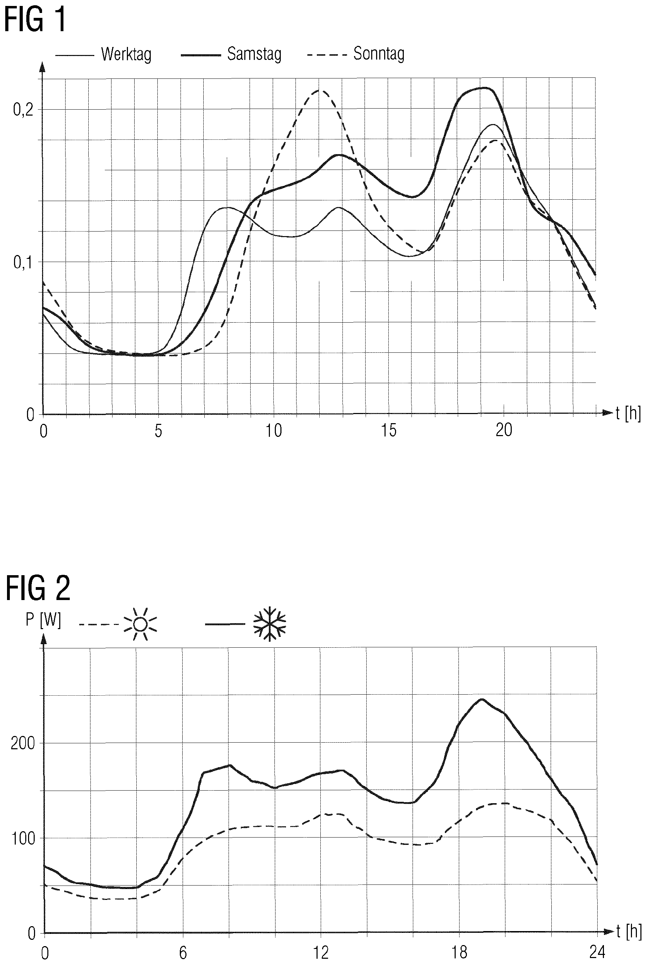

In den Figuren 1 und 2 sind ein Lastprofil in Abhängigkeit von der wochentageabhängigen Energieversorgung, sowie ein Lastprofil in Abhängigkeit von der Jahreszeit gezeigt. Dabei kann beispielsweise eine Leistung P in Watt oder anteilsmäßig in Prozent über der Zeit t aufgetragen sein. Ein Lastprofil bezeichnet im Allgemeinen eine Belastungskurve über einen bestimmten Zeitraum, die häufig ein wiederkehrendes Verhalten aufweist. Ein solches Profil kann in verschiedenen Bereichen wie der Energieversorgung, beispielsweise der Stromversorgung, beobachtet werden. Das Verbraucherverhalten weist zu bestimmten Uhrzeiten, vergleiche Figur 1, oder in verschiedenen Jahreszeiten, vergleiche Figur 2, typische Muster auf. Diese Lastprofile können aufgrund von Erfahrungswerten prognostiziert, abgeschätzt oder stochastisch berechnet werden.

Eine Belastung kann als Leistung, aber auch als Kraft oder als Erwärmung durch äußere Einflüsse interpretiert werden, wobei die Leistung am häufigsten verwendet wird. Im Kontext der vorgeschlagenen Lösung sind demnach Temperaturprofile bevorzugt eingesetzt. Alternativ können aber auch Lastprofile herangezogen werden, da die Temperatur eng mit der Last verbunden ist. Eine Belastung führt im Allgemeinen zu einem Temperaturanstieg.

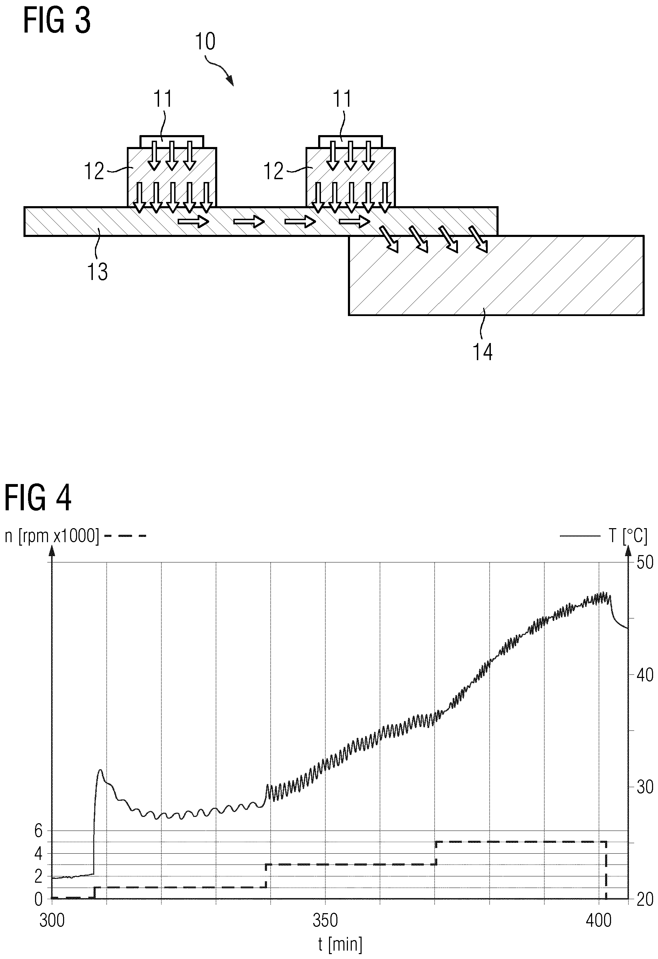

In der Figur 3 ist eine schematische Seitenansicht eines zu entwärmenden elektrischen Systems 10 mit elektronischen Bauelementen 11 gezeigt, welche mittels wärmeleitfähiger Anbindung 12 entwärmt werden können. Die zeitliche Komponente spielt hierbei eine entscheidende Rolle. Beispielsweise umfasst ein System 10 Kühler 12,14, Bodenplatte, Substrate und Gehäuse. Das Wärmemanagement eines Systems 10, wird dann so gesteuert, dass in den thermische Pfad, durch Pfeile in Figur 3 dargestellt, eingegriffen werden kann. Das bedeutet, dass vor einem Lastfall, eine möglichst effiziente Vorkühlung der Kühlvorrichtung 12 der Wärmequelle 11 stattfindet, oder allgemein eine Vorkühlung des gesamten Kühlsystems oder der Kühlkomponente 14 zur Wärmeabfuhr an die Systemumgebung.

Die beschriebenen Prinzipien lassen sich auf verschiedene elektronische Industrieprodukte, insbesondere elektrische Antriebe, anwenden. Es gibt vorab bestimmte Ereignisse, bei denen der Einfluss auf die Belastung bekannt ist, entweder aufgrund von Erfahrung oder Berechnung. Beispiele dafür sind der Produktionsbeginn und das Ende sowie Pausen, die entsprechend dem Schichtplan festgelegt werden. Der Produktionsablauf kann ebenfalls einen vorhersagbaren Einfluss haben, zum Beispiel wenn eine Anlage ihre Arbeit aufnimmt, nachdem eine andere Anlage ein Werkstück fertig bearbeitet hat. Die Dauer dieses Ablaufs ist aus Erfahrung bekannt und ermöglicht die Ableitung des Schichtplans für die entsprechenden Anlagen. Ein weiteres Beispiel ist ein thermischer "Schock" in Anlagen, in denen eine starke Kühlung, zum Beispiel in einem Windkanal, oder eine starke Erwärmung, beispielsweise in einem Hochofen, auf Knopfdruck erfolgt. Solche Ereignisse sind prognostizierbar. Aufgrund dieser Informationen kann der Zeitpunkt bestimmt werden, zu dem eine Belastung zu erwarten ist. Die Höhe der Belastung kann ebenfalls aus Erfahrung prognostiziert werden, zum Beispiel anhand vergangener Messungen der elektrischen Leistung, oder sie kann aus Datenblattangaben abgeleitet werden. Beides kann durch Berechnung oder Messung erfolgen. Auf dieser Grundlage lassen sich einfache Abläufe in der Kühlstrategie implementieren.

Ein Beispiel für einen Produktionsablauf wäre demnach, dass bekannt ist, dass Anlage B etwa 30 Minuten nach dem Start von Anlage A ihre Arbeit aufnimmt. Nach 25 Minuten wird Anlage B vorgekühlt. Im Zusammenhang mit der anderen Erfindungsmeldung arbeitet Anlage A 25 Minuten lang mit der gemeinsamen Kühlung von Anlage A und B ("Cool Shift"). Nach 25 Minuten wird die Kälteleistung dort reduziert, um Anlage B die Möglichkeit zu geben, sich vorzukühlen. Nach 30 Minuten wird Anlage A weitere 5 Minuten lang rückgekühlt, um für den nächsten Arbeitstakt wieder auf ihre Basistemperatur zurückzukehren. Anschließend kann Anlage B die volle kombinierte Kühlleistung nutzen. Die Basistemperatur hängt dabei von noch weitere Faktoren ab. Mit einzubeziehen wären beispielsweise die Umgebungstemperatur sowie die Lasthistorie. Zum Beispiel erhöht sich der Widerstand von Kupfer, und damit die Verlustleistung bei konstantem Strom, um rund 40% bei einer Temperaturerhöhung von 20°C nach 100°C.

Darüber hinaus können direkte Messungen an der Anlage oder der zu kühlenden Komponente 10, 11 genutzt werden, um den Start der Vorkühlung zu bestimmen. Mit dieser Methode ist es nicht mehr erforderlich, den genauen Zeitpunkt des Eintritts oder das genaue Profil aus Erfahrung vorherzusagen. Beispielsweise sei das Lastprofil, bestimmt durch die Drehzahl und deren Dauer, für einen Fertigungsschritt bekannt. Die Kühlung erfolgt üblicherweise drehzahlgesteuert, wobei bei geringer Last eine geringere Drehzahl angewendet wird, was zu einer schwächeren Kühlung und einem geringeren Leistungsaufwand führt. Es gibt auch andere Fertigungsschritte auf dieser Anlage mit unterschiedlichen Lastprofilen, z.B. mit einem Start bei 5000 Umdrehungen pro Minute und einer schrittweisen Reduzierung der Drehzahl. Die Steuerung erkennt, zum Beispiels mittels eines Temperatursensors, den Einschaltpeak beim Start des Motors. Anschließend wird die abnehmende Temperatur erkannt und wann der Motor nahezu im Temperaturgleichgewicht läuft, vgl. Figur 4. In der Figur 4 ist eine Temperaturverlaufskurve einer elektrischen Maschine, insbesondere eines Elektromotors bei Betrieb mit veränderlicher Drehzahl n gezeigt.

Als Aktion wird beispielsweise die Drehzahlregelung der Kühlung überschrieben und mit voller Leistung gekühlt. Der Motor würde somit bereits im ersten Lastschritt des Lastprofils für die bekannten weiteren Lastschritte vorgekühlt. Dadurch sinkt die Temperatur und es entstehen weniger Verluste im Kupfer aufgrund des geringeren Widerstands. Der Temperaturanstieg in den folgenden Lastschritten ist ebenfalls geringer. Insgesamt entstehen weniger Motorverluste. Die Temperaturdifferenz zwischen dem Start und dem Ende des Profils ist geringer und damit auch die Alterungsauswirkung.

Für ein anderes angedeutetes Lastprofil, bei dem sich die maximale Temperatur eher am Anfang des Fertigungsschritts einstellt und mit den weiteren Lastschritten tendenziell abnimmt, ist eine Drehzahlsteuerung der Kälteleistung zur Energieeinsparung sinnvoll. In diesem Fall wird die Drehzahlsteuerung nicht überschrieben.

Ein weiteres Beispiel für eine Steuerung ergibt sich aus dem zuvor beschriebenen Beispiel, wobei die Messung an einem anderen Ort erfolgt. Angenommen, das vorstehend beschriebene Beispiel bezieht sich auf eine Drehmaschine, die ein bestimmtes Werkstück mit einem bestimmten Lastprofil herstellt. Nach der Bearbeitung würde das Werkstück an eine weitere Bearbeitungsstation B weitergeleitet, zum Beispiel zum Sägen. Wenn es sich um ein anderes Werkstück handeln würde, könnte eine ganz andere Bearbeitungsstation C das nächste Ziel sein. Da die Drehmaschine erkennt, welches Werkstück hier bearbeitet wurde, kann Station B darüber informiert werden und gegebenenfalls vorkühlen.

Ein daran anknüpfendes Beispiel zur Vorab-Berechnung, könnte folgendermaßen aussehen: Der Drehmaschine würde im Voraus ein Drehzahl-Profil, ein prognostiziertes Drehmoment für jede Drehzahl und die Dauer des jeweiligen Lastschrittes anhand von Drehzahl und Drehmoment einprogrammiert. Ein Sensor würde die Temperatur des Motors messen, während ein weiterer Sensor die Umgebungstemperatur erfasst. Aus den gegebenen Drehzahl- und Drehmomentwerten kann die mechanische Leistungsabgabe des Motors berechnet werden. Anhand von Herstellerangaben oder historischen Messdaten kann die Verlustleistung berechnet werden. Bei Bedarf könnte die aktuelle Kupfertemperatur ergänzend berücksichtigt werden, um die Verlustleistung entsprechend anzupassen. Die Messung der Umgebungstemperatur ermöglichte eine bessere Berücksichtigung der Wärmeabgabe an die Umgebung während der Fertigung.

Basierend auf diesen Daten wird eine Prognose für die mittlere Temperatur, die maximale Temperatur und die Verlustenergie erstellt. Parallel dazu wird beispielsweise berechnet, wie sich eine Vorkühlung auf die Verlustenergie und die genannten Temperaturen auswirkt. Es wird entschieden, ob sich die Vorkühlung energetisch lohnt und ob eine Begrenzung der maximalen Temperatur durch Vorkühlung notwendig oder erwünscht ist. Im Falle einer teilbaren Kühlung mit einer zweiten Anlage könnte die Aufteilung der Kühlung auf die Anlagen optimiert werden.

Ein alternatives Beispiel könnte eine Sortieranlage sein, welche die Qualität hergestellter Waren bewertet und diese entsprechend aussortiert oder in verschiedene Kategorien einsortiert. Diese Information wird an die nachgelagerte Fertigungsanlage weitergegeben, um die Kühlung zu steuern. Es besteht auch die Möglichkeit, die Kälteleistung aufzuteilen.

Wie man an den Beispielen erkennt, gibt es vielfältige Möglichkeiten, die Temperaturlastsituationen unterschiedlichster Anwendungen zu prognostizieren, oder zu beurteilen, oder zu berechnen und das Ergebnis dieses Vorgehens zur Verbesserung des Betriebs oder zur Optimierung der Anlagen und der elektrischen System darin zu nutzen.

Das Problem wird also durch ein innovatives dynamisches Kühlkonzept effektiv gelöst. Dieses Konzept besteht aus drei Schritten, um eine optimierte Kühlung zu erreichen.

Als erster Schritt wird eine zeitliche Vorhersage des Lastprofils genutzt. Dadurch stehen Informationen zur Verfügung, wann und in welchem Umfang ein Lastanstieg zu erwarten ist.

Auf Grundlage dieser Vorhersage wird im zweiten Schritt die benötigte Kühlleistung abgeschätzt.

Im dritten Schritt wird basierend auf diesen Informationen eine zusätzliche Kühlleistung bereitgestellt. Dies erfolgt bevorzugt durch eine vorgezogene Kühlung vor dem eigentlichen Lastfall, um die Temperatur vorab zu senken und somit ein größeres Temperaturgefälle zur Verfügung zu haben. Zusätzlich könnten auch benachbarte Kühlkapazitäten hinzugeschalten werden mittels eines Kühlshifts.

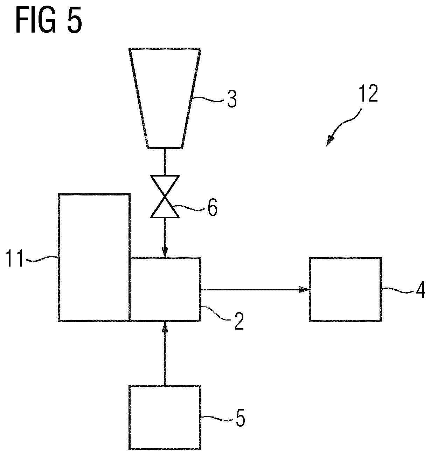

Durch diese Maßnahmen wird die maximale Temperatur der Wärmequelle im Lastfall reduziert. Hierbei spielt die zeitliche Komponente eine entscheidende Rolle, da die Temperatur des Systems, im Vorfeld so gesteuert werden muss, dass der thermische Pfad ideal reagieren kann. Das Ziel ist es, im Lastfall eine möglichst effiziente Entwärmung der Wärmequelle zu gewährleisten. Das vorzeitige Herunterkühlen der Wärmesenken, wie zum Beispiel der Kühler, kann auf verschiedene Weise erfolgen. Eine bevorzugte Möglichkeit ist eine chemische Methode, bei der beispielsweise ein Salz in Lösung geht. Dies führt aufgrund der Lösungsenthalpie zu einer Absenkung der Lösungstemperatur und demnach zu einer Kühlungwirkung, vgl. Figur 5.

In Figur 5 ist nun noch schematisch ein Beispiel für einen Aufbau einer chemischen Kühlung gezeigt: Ein zu kühlendes Element 11 ist dazu mit einer Kühlvorrichtung 12 thermisch leitend verbunden. Insbesondere schließt ein Behälter 2 direkt an das zu kühlende Element 11 an. In diesem Behälter 2 befindet sich das Lösungsmittel. Sobald die aktive Vorkühlung benötigt wird, wird über eine Dosiervorrichtung 6 aus einem Vorratsbehälter 3 der zu lösende Stoff in den Behälter 2 und somit in das Lösungsmittel zugeführt. Durch die positive Lösungsenthalpie kühlt sich das Lösungsmittel ab und somit wird dem thermisch leitend verbundenen Element 11 Wärme entzogen. Dieser Prozess kann so lange wiederholt werden, bis die Mischung gesättigt ist. Dann wird die Mischung beispielsweise in einen Restebehälter 4 gepumpt und mit neuem Lösungsmittel aus einem Lösungsmittelvorrat 5 ersetzt. Die gesättigte Lösung kann in einem separaten Prozess, zum Beispiel durch Destillation wieder getrennt werden in Lösungsmittel und zu lösenden Stoff und wiederverwendet werden.

Eine weitere Option ist die elektrische Methode, bei der piezoelektrische Elemente wie Peltierelemente oder handelsübliche Kälteaggregate durch elektrischen Betrieb Wärme von einem Objekt entziehen können. Dies kann durch die Kühlung von Phase-Change-Materialien verstärkt werden, indem sie von flüssig auf fest übergehen und die Schmelzenthalpie zur Wärmekapazität hinzugerechnet wird. Schließlich kann das vorzeitige Herunterkühlen auch durch physikalische oder mechanische Methoden erreicht werden. Zum Beispiel kann durch die Expansion eines Gases Wärme aus der Umgebung entzogen werden. Dies kann durch das Einbringen von Gaskartuschen im System realisiert werden. Zudem kann eine höhere Wärmekapazität erreicht werden, indem eine zusätzliche Wärmekapazität bewegt wird. Durch diese verschiedenen Ansätze wird eine effiziente Nutzung der Wärmekapazitäten ermöglicht, um das System optimal zu kühlen.

Die vorgeschlagene Lösung bietet eine Reihe von Vorteilen, die wie folgt zusammengefasst werden können: Erstens ermöglicht sie eine effiziente Entwärmung von Systemen in Abhängigkeit des Lastprofils. Durch die Berücksichtigung der zeitlichen Vorhersage des Lastprofils kann die Kühlung entsprechend angepasst werden, um eine optimale Entwärmung zu gewährleisten. Zweitens trägt sie zur Erhöhung der Systemlebensdauer bei, indem sie die maximale Hotspottemperatur reduziert. Durch die effiziente Vorkühlung wird die Belastung der Komponenten verringert und potenzielle Schäden durch Überhitzung vermieden. Drittens führt sie zu einer Steigerung des Wirkungsgrades, da niedrigere Temperaturen erreicht werden. Durch die effiziente Entwärmung wird die Energieeffizienz des Systems verbessert. Viertens kann sie zu erheblichen Kosteneinsparungen führen, da das System eine längere Lebensdauer hat. Dadurch wird vermieden, dass das System vorzeitig ausgetauscht werden muss, was mit zusätzlichen Kosten verbunden wäre.

Insgesamt bietet die vorgeschlagene Lösung eine Reihe von Vorteilen, darunter eine effiziente Entwärmung, eine erhöhte Systemlebensdauer, einen verbesserten Wirkungsgrad und potenzielle Kosteneinsparungen durch ein längeres End-of-Life des Systems.

Obwohl die Erfindung im Detail durch das Ausführungsbeispiel näher illustriert und beschrieben wurde, ist die Erfindung nicht durch offenbarte Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- P: Leistung in Watt [W]
- t: Zeit in Stunden [h] oder in Minuten [min]
- T: Temperatur in Grad Celsius [°C]
- n: Anzahl der Umdrehungen einer elektrischen Maschine in [rpm]
- 2: Behälter mit Lösungsmittel
- 3: Behälter mit zu lösendem Stoff
- 4: Restebehälter
- 5: Vorratsbehälter Lösungsmittel
- 6: Dosiervorrichtung
- 10: elektrisches System
- 11: elektronisches Bauelement, zu entwärmende Komponente
- 12: wärmeleitfähiger Anbindung, lokale Kühlkomponente, Teilkühlsystem, beispielsweise Kühlkörper
- 14: Kühlkomponente zur Wärmeabfuhr an die Systemumgebung
Zusammenfassend wird also festgehalten, dass die vorstehend beschriebene innovative Lösung, den Wärmefluss von einer Hitzequelle in einem elektrischen System zum Kühler, bis hin zur Wärmeabgabe an die Systemumgebung, effizienter gestaltet. Gleichzeitig wird eine zeitliche Vorhersage eines Temperaturereignisses, beispielsweise anhand eines Lastprofils, berücksichtigt. Die Wärmekapazitäten des zu entwärmenden Systems werden effizienter und intelligenter genutzt.

## Patentansprüche

1. Verfahren zur Entwärmung eines elektrischen Systems (10) umfassend,
Erfassen einer zeitlichen Vorhersage eines Lastprofils,
Berechnung einer benötigten maximalen Kühlleistung im nächsten Lastfall, und
Erhöhung der Kühlleistung eines Kühlsystems durch eine Vorkühlung der Kühlkomponente (12) des Kühlsystems in einem vorgebbaren zeitlichen Abstand vor dem nächsten Lastfall.

2. Verfahren nach Anspruch 1, wobei eine Vorkühlung mittels einer chemischen Kühlkomponente (12) erfolgt, welche wenigstens einen zu lösenden Stoff (3) und ein Lösungsmittel umfasst, deren Lösungsenthalpie positiv ist, indem ein Teil des zu lösenden Stoffes (3) dem Lösungsmittel zugeführt wird.

3. Verfahren nach Anspruch 1 oder 2, wobei eine Vorkühlung mittels einer elektrischen Kühlkomponente erfolgt, insbesondere mittels eines piezoelektrischen Elements, eines Peltierelements oder eines Kälteaggregats.

4. Verfahren nach einem der vorstehenden Ansprüche, wobei eine Vorkühlung mittels Kühlung eines Phase-Change-Materials bis über den Phasenübergang erfolgt.

5. Verfahren nach einem der vorstehenden Ansprüche, wobei eine Vorkühlung mittels einer Gasexpansion erfolgt.

6. Verfahren nach einem der vorstehenden Ansprüche, wobei eine Vorkühlung mittels Anbindung einer zusätzlichen beweglichen Kühlkomponente erfolgt.

7. Vorrichtung zur Entwärmung eines elektrischen Systems aufweisend,
eine Steuereinheit, welche zum Erfassen einer zeitlichen Vorhersage eines Lastprofils ausgestaltet ist,
eine Recheneinheit, ausgestaltet zur Abschätzung einer benötigten maximalen Kühlleistung im nächsten Lastfall, und
ein Kühlungssystem mit wenigstens einer Kühlkomponente, wobei die Steuereinheit des Weiteren ausgestaltet ist, auf Basis der abgeschätzten benötigten maximalen Kühlleistung, die Kühlkomponente in einem vorgebbaren zeitlichen Abstand vor dem nächsten Lastfall vorzukühlen.

8. Vorrichtung nach Anspruch 7, wobei das Kühlsystem wenigstens eine (chemische) Kühlkomponente umfasst, welche wenigstens einen zu lösenden Stoff und ein Lösungsmittel umfasst, deren Lösungsenthalpie positiv ist und wobei die Steuereinheit ausgestaltet ist, einen Teil des zu lösenden Stoffes dem Lösungsmittel zuzuführen.

9. Vorrichtung nach einem der Ansprüche 7 oder 8, wobei das Kühlsystem wenigstens eine elektrische Kühlkomponente umfasst, insbesondere ein piezoelektrisches Element, ein Peltierelement oder ein Kälteaggregat.

10. Vorrichtung nach einem der Ansprüche 7 bis 9, wobei das Kühlsystem wenigstens eine Kühlkomponente mit einem Phase-Change-Material umfasst.

11. Vorrichtung nach einem der Ansprüche 7 bis 10, wobei das Kühlsystem wenigstens eine Kühlkomponente mit einer Gaskartusche umfasst.

12. Vorrichtung nach einem der Ansprüche 7 bis 11, wobei das Kühlsystem wenigstens eine mechanisch verschiebbare Kühlkomponente aufweist.
